# EUROPEAN PATENT APPLICATION

(11) **EP 2 284 988 A1**
(43) Date of publication of application: **16.02.2011**
(21) Application number: 09746309.5
(22) Date of filing: 06.03.2009
(51) Int. Cl.: H03B 5/32

(54) **OSCILLATOR**

(30) Priority: 13.05.2008 JP 2008125582; 03.03.2009 JP 2009049097
(71) Applicant: Nihon Dempa Kogyo Co., Ltd., Shibuya-ku Tokyo 151-8569 (JP)
(72) Inventor: HASEGAWA, Kazunori, Sayama-shi Saitama 350-1321 (JP); YAMAKAWA, Tsutomu, Sayama-shi Saitama 350-1321 (JP)
(74) Representative: Liesegang, Eva
(86) International application number: PCT/JP2009/001019
(87) International publication number: WO 2009/139102

(57) **Abstract**

Provided is a small-size and highly stable oscillator which can easily correct a frequency shift caused by a temperature fluctuation. The oscillator includes: an overtone crystal unit (11) of three or higher dimension; an oscillation circuit (12) which is connected to the crystal unit (11) and outputs an oscillation frequency; a divider (13) which divides the oscillation frequency and outputs the divided frequencies to a system device processing unit (2); a temperature sensor (16) which detects a temperature around the crystal unit (11); and a memory (17) which stores information for correcting a frequency shift of an oscillation frequency according to the temperature characteristic of the crystal unit (a coefficient of an equation for calculating a correction amount of a frequency shift or the frequency shift corresponding to the temperature) and provides information to be used for correcting the frequency shift to the system device processing unit (2).

## Description

### Technical Field

The present invention relates to an oscillator using crystals, and more particularly, it relates to a highly stable and inexpensive oscillator which realizes miniaturization in a temperature compensated crystal oscillator (TCXO) or a voltage controlled TCXO (VC-TCXO).

### Background Art

### [Conventional Art]

Heretofore, in a temperature compensated crystal oscillator (TCXO) or a voltage controlled TCXO (VC-TCXO), temperature compensation is performed, and control is executed so that a frequency deviation detected by a digital signal processing unit such as a baseband unit of a mounted system device (e.g., a cellular phone or the like) is fed back to the signal processing unit or fed back to a frequency control voltage of the VC-TCXO.

### [Prior Art]

It is to be noted that examples of a concerned prior art include Japanese Patent Application Laid-Open No. 09-321539 (Patent Document 1), Japanese Patent Application Laid-Open No. 11-065694 (Patent Document 2) and Japanese Patent Application Laid-Open No. 2003-324318 (Patent Document 3).

Patent Document 1 discloses a digital control type oscillation circuit in which an AFC circuit calculates a frequency deviation from an error of a frequency output from the oscillation circuit, a CPU adds a correction value corresponding to the frequency deviation to an A/D converter, and a value output to the oscillation circuit is stored as the value corresponding to a value output from a temperature sensor in a memory.

Patent Document 2 discloses a software clock correction system which beforehand measures temperature characteristics of a crystal oscillation circuit, stores and holds, in a memory, a value deviating from a standard value of an oscillation frequency in each temperature region in a frequency fluctuation table, searches for the frequency fluctuation table based on a measured ambient temperature, reads the deviation amount of a frequency output from the crystal oscillation circuit, calculates deviation from the standard value, and adds or subtracts the deviation to or from time information to correct gain or delay of time from the standard value.

Patent Document 3 discloses a receiving device using a piezoelectric oscillator in which a temperature sensor measures a temperature in the vicinity of a piezoelectric oscillator, and a control circuit outputs, from a memory, an approximate curve coefficient and offset data based on the temperature characteristics of the piezoelectric oscillator. A CPU connected to the piezoelectric oscillator substitutes the measured temperature, the approximate curve coefficient and the like into an approximate expression for calculating a frequency deviation to calculate the frequency deviation, and offsets a frequency range in which a signal corresponding to the frequency deviation is searched.

Patent Document 1: Japanese Patent Application Laid-Open No. 09-321539
Patent Document 2: Japanese Patent Application Laid-Open No. 11-065694
Patent Document 3: Japanese Patent Application Laid-Open No. 2003-324318

### Disclosure of the Invention

### Problem to be solved by the Invention

However, in the above conventional circuit to perform temperature compensation in an oscillator, there has been a problem that a temperature compensation circuit and a variable displacement element for the circuit are required, and the circuit cannot be miniaturized and is hence expensive.

Moreover, according to Patent Document 1, in the digital control type oscillation circuit, the AFC circuit calculates the frequency deviation, and the CPU obtains the corresponding correction value. Consequently, there has been a problem that the scales of the circuits in the oscillation circuit enlarge, and oscillation in a highly stable state cannot be realized.

Furthermore, in Patent Document 2, the system comprises the temperature sensor which measures the temperature, but the sensor is not disposed in the crystal oscillation circuit, but is disposed outside. Additionally, in Patent Document 2, there has been a problem that the crystal oscillation circuit cannot be distributed as a single component unit, but has to be designed as the whole computer, the crystal oscillation circuit cannot arbitrarily be incorporated when designing the whole circuit, and the degree of freedom in the design is disturbed.

Moreover, according to Patent Document 3, in accordance with the measured temperature supplied from the piezoelectric oscillator, and the approximate curve coefficient and the offset data based on the temperature characteristics, such a frequency range as to capture a position measurement signal received from a GPS satellite in a signal processing circuit is changed. However, there has been a problem that it is not possible to easily correct the frequency deviation included in a reference signal by the signal processing circuit while highly stabilizing the reference signal of a clock or the like output form the oscillator.

Furthermore, in Patent Document 3, in the same manner as in Patent Document 2, there has been a problem that the crystal oscillation circuit cannot be distributed as the single component unit, but has to be designed as the whole receiving device for changing such a frequency range as to capture the position measurement signal received from the GPS satellite, the crystal oscillation circuit cannot arbitrarily be incorporated when designing the whole circuit, and the degree of freedom in the design is disturbed.

Therefore, in Patent Document 3, there has been a problem that it is not possible to easily correct the reference signal while supplying a highly stable reference signal, and it is not possible to realize a configuration for distributing the crystal oscillation circuit as the single unit.

The present invention has been developed in view of the above situation, and an object thereof is to provide an oscillator which easily corrects a frequency deviation caused by a temperature fluctuation, achieves miniaturization and realizes a highly stable state.

### Means for Solving the Problem

According to the present invention for solving the above problem of the conventional example, there is provided an oscillator which supplies a reference signal to a system device processing unit, comprising: a third or higher overtone crystal unit; an oscillation circuit which is connected to the crystal unit to output an oscillation frequency to the system device processing unit; a temperature sensor which detects a temperature in the vicinity of the crystal unit; and a memory which stores information to correct a frequency deviation of the oscillation frequency based on temperature characteristics of the crystal unit and which supplies the information to correct the frequency deviation to the system device processing unit.

In the present invention, the above oscillator further comprises a buffer which is interposed between the oscillation circuit and the system device processing unit to input the oscillation frequency from the oscillation circuit and to output the oscillation frequency to the system device processing unit, thereby suppressing an influence of a load on an output side.

In the present invention, the above oscillator further comprises a divider which is interposed between the oscillation circuit and the buffer to divide the oscillation frequency from the oscillation circuit.

In the present invention, the above oscillator further comprises a buffer which is interposed between the oscillation circuit and the divider to suppress an influence of a load in the divider.

According to the present invention, in the above oscillator, the memory stores, as the information to correct the frequency deviation, a frequency deviation amount corresponding to a value of the temperature in a table, and outputs contents of the table to the system device processing unit.

According to the present invention, in the above oscillator, the memory stores, as the information to correct the frequency deviation, a coefficient of a calculating equation to calculate the frequency deviation amount corresponding to the value of the temperature, and outputs the coefficient of the calculating equation to the system device processing unit.

According to the present invention, in the above oscillator, constituent components other than the crystal unit are integrated and disposed in an integrated circuit.

### Effect of the Invention

According to the present invention, provided is an oscillator in which an oscillation circuit is connected to a third or higher overtone crystal unit to output an oscillation frequency to a system device processing unit, a temperature sensor detects a temperature around the crystal unit, and a memory stores information to correct a frequency deviation of the oscillation frequency based on temperature characteristics of the crystal unit, and supplies the information to correct the frequency deviation to the system device processing unit, thereby producing an effect that the frequency deviation caused by a temperature fluctuation is easily corrected by the system device processing unit, miniaturization is achieved and a highly stable state can be realized.

### Brief Description of the Drawings

FIG. 1 is a configuration block diagram of an oscillator according to an embodiment of the present invention;
FIG. 2 is a frequency-temperature characteristic diagram of a fundamental wave and a third harmonic wave; and
FIG. 3 is a diagram showing an oscillation circuit and a circuit of a crystal unit in the oscillator. Description of Reference Numerals

1 oscillator
2 system device processing unit
11 crystal unit
12 oscillation circuit (OSC)
13 divider (Div)
15 buffer (Buff)
16 temperature sensor
17 memory

### Best Mode for Carrying out the Invention

An embodiment of the present invention will be described with reference to the drawings.

### [Outline of Embodiment]

An oscillator according to the embodiment of the present invention is a crystal oscillator which supplies a reference signal to a system device processing unit. The oscillator comprises a third or higher overtone crystal unit; an oscillation circuit which is connected to the crystal unit to output an oscillation frequency to the system device processing unit; a temperature sensor which detects a temperature around the crystal unit; and a memory which stores information to correct a frequency deviation of the oscillation frequency based on temperature characteristics of the crystal unit and which supplies the information to correct the frequency deviation to the system device processing unit, whereby the frequency deviation caused by a temperature fluctuation is easily corrected in the system device processing unit, miniaturization is achieved and a highly stable state can be realized.

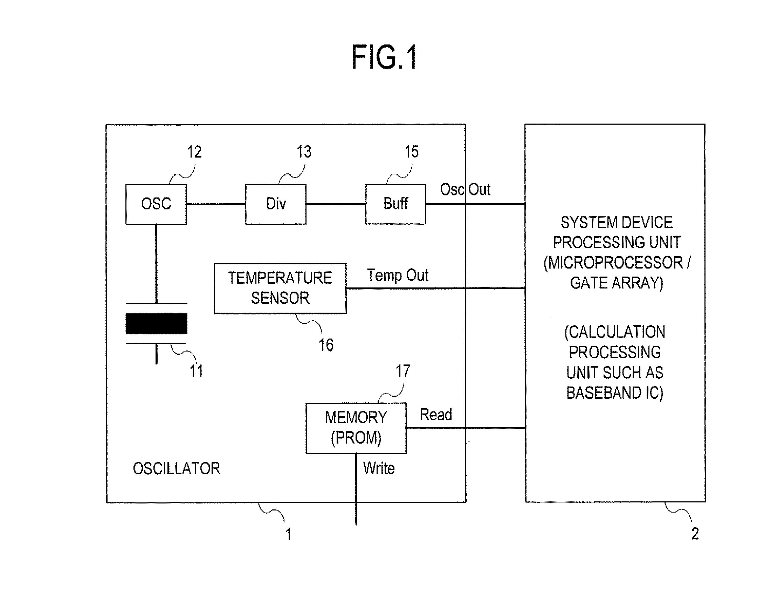

### [the Whole Oscillator: FIG. 1]

The oscillator according to the embodiment of the present invention will be described with reference to FIG. 1. FIG. 1 is a configuration block diagram of the oscillator according to the embodiment of the present invention.

An oscillator (the present oscillator) 1 according to the embodiment of the present invention is connected to a system device processing unit 2 as shown in FIG. 1, and has an internal configuration basically including a crystal unit 11, an oscillation circuit (OSC) 12, a divider (Div) 13, a buffer (Buffer) 15, a temperature sensor 16, and a programmable read only memory (PROM) as a memory 17.

Moreover, the system device processing unit 2 comprises a microprocessor, a gate array or the like, and corresponds to a calculation processing unit such as a baseband IC in a radio communication device.

It is to be noted that the system device processing unit 2 is arbitrarily designed by a customer who incorporates the oscillator 1, and the oscillator 1 supplies information and a signal necessary for correcting a frequency fluctuation.

### [Components of Oscillator]

Next, components of the present circuit will specifically be described.

### [Crystal Unit 11]

The crystal unit 11 is a third or higher overtone crystal unit. The third or higher overtone crystal unit is used to operate the oscillator in a highly stable (high Q) state.

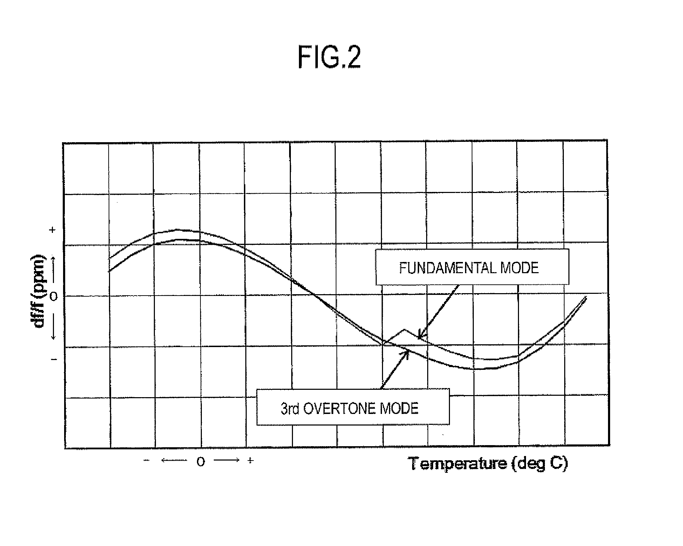

### [Characteristics of Fundamental Wave and Third Harmonic Wave: FIG. 2]

Here, a frequency-temperature characteristic curve of a fundamental wave crystal unit and a third harmonic wave crystal unit (a third overtone crystal unit) will be described with reference to FIG. 2. FIG. 2 is a frequency-temperature characteristic diagram of a fundamental wave and a third harmonic wave. In FIG. 2, the abscissa indicates a temperature, and the ordinate indicates a frequency variance ratio.

In the crystal unit, a main vibration of the unit and an unnecessary vibration other than the main vibration are combined to indicate a discontinuous frequency variance with respect to the temperature sometimes as shown in FIG. 2. However, as compared with the fundamental wave (a fundamental mode), in the third harmonic wave (a 3rd overtone mode), such a discontinuous frequency variance rarely appears, and it is easy to obtain the crystal unit having satisfactory frequency-temperature characteristics.

### [Oscillation Circuit (OSC) 12]

The oscillation circuit (OSC) 12 is connected to the crystal unit 11 to oscillate at a desirable frequency, thereby outputting a signal to the divider 13.

### [Divider (Div) 13]

The divider (Div) 13 divides the frequency signal input from the oscillation circuit 12 to output the signal to the buffer 15.

It is to be noted that the buffer may be interposed between the oscillation circuit 12 and the divider 13.

### [Buffer (Buffer) 15]

The buffer (Buffer) 15 is an amplifier which is interposed to suppress an influence of a load in the system device processing unit 2 and to obtain a desirable output amplitude.

An output signal (Osc Out) from the buffer 15 is utilized as a clock with respect to the system device processing unit 2.

### [Temperature Sensor 16]

The temperature sensor 16 measures a temperature around the crystal unit 11, and outputs a measured temperature value (Temp Out) as a digital or analog value to the system device processing unit 2. That is, the temperature sensor 16 supplies temperature information for temperature compensation.

It is to be noted that when the value of the temperature is the analog value, the value is input into the system device processing unit 2, and converted into a digital signal.

Here, a main factor which determines a frequency stability of the oscillator is usually the crystal unit 11 which has a higher influence degree than the oscillation circuit 12. This is because the oscillation frequency is influenced by the load when an oscillation circuit 12 side is seen from the crystal unit 11, but a frequency fluctuation based on the frequency-temperature characteristics of the crystal unit 11 itself is larger than that of the oscillator 1 caused by the fluctuation of a load capacity of the oscillation circuit 12.

### [Memory 17]

The memory 17 of the PROM beforehand stores information on temperature characteristics of the crystal unit 11, and outputs the information to the system device processing unit 2. The information in the memory 17 is beforehand acquired by actual measurement, numerical calculation is additionally performed if necessary, and the information is beforehand set in accordance with the temperature characteristics before shipping the present oscillator 1.

As the information on the temperature characteristics stored in the memory 17, the correction amount of the frequency deviation corresponding to the temperature is stored in a table (a correction amount table), or a coefficient of an equation (a correcting equation) to calculate the frequency deviation in accordance with the temperature characteristics is stored.

Here, the memory 17 may be an electrically programmable read only memory (EPROM) or an electrically erasable programmable read only memory (EEPROM).

### [Another Configuration in the present Oscillator]

It is to be noted that the present oscillator 1 may have a configuration from which the divider 13 is removed if the divider is not necessary.

Moreover, in the present oscillator 1, the constituent components other than the crystal unit 11 may be integrated to obtain a configuration of an integrated circuit.

### [Operation of Embodiment]

In the present oscillator 1, the oscillation frequency obtained from the oscillation circuit 12 connected to the third or higher overtone crystal unit 11 is output, divided by the divider 13 and output to the system device processing unit 2 via the buffer 15.

Moreover, in the present oscillator 1, the temperature sensor 16 detects the temperature around the crystal unit 11, outputs the numeric value of the detected temperature to the system device processing unit 2, and outputs, from the memory 17 to the system device processing unit 2, the contents of the correction amount table or the value obtained by the correcting equation by use of the coefficient of the correcting equation.

The system device processing unit 2 acquires the signal (Osc Out) input from the buffer 15 of the present oscillator 1, the value of the temperature from the temperature sensor 16, and the correction amount of the frequency deviation obtained by using the correction amount table or the coefficient of the correcting equation from the memory 17, to perform calculation and signal processing in the system device processing unit 2, thereby performing frequency deviation correction processing.

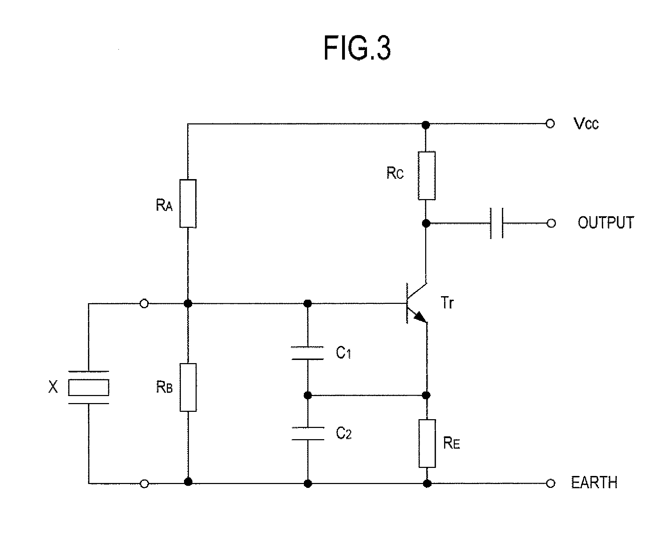

### [Configuration of Oscillator: FIG. 3]

The oscillation circuit and the circuit of the crystal unit in the above oscillator will be described with reference to FIG. 3. FIG. 3 is a diagram showing the oscillation circuit and the circuit of the crystal unit in the oscillator.

As shown in FIG. 3, the oscillation circuit and the crystal unit in the oscillator have a usual Colpitts type feedback amplification circuit.

In FIG. 3, signals at both ends of a crystal unit X are divided by capacitors C₁ and C₂, one of the capacitors is connected to a base terminal of a transistor Tr for oscillation, and the other capacitor is connected to an emitter terminal of the transistor Tr. It is to be noted that R_{A} and R_{B} are bleeder resistors for applying a fixed bias to the base terminal of the transistor Tr, R_{E} is a negative feedback resistor connected to an emitter, and R_{C} is a negative feedback resistor connected to a collector.

### [Effect of the Embodiment]

According to the present oscillator, the frequency deviation of the output signal corresponding to the temperature fluctuation is not corrected in the circuit, but the output signal including the frequency deviation is output as a reference signal, and the value of the temperature in the oscillator and the information on the temperature characteristics of the crystal unit are simultaneously supplied, thereby producing an effect that in the system device processing unit 2, the input signal is subjected to signal processing by use of the reference signal. Moreover, the frequency deviation can easily be corrected in accordance with the value of the temperature and the information on the temperature characteristics.

Furthermore, according to the present oscillator, the buffer 15 is disposed in the output stage of the reference signal, or the buffer is interposed between the oscillation circuit 12 and the divider 13, thereby producing an effect that the output reference signal cannot easily be influenced by the load of the system device processing unit 2.

In addition, according to the present oscillator, as the crystal unit, the third or higher overtone crystal unit 11 is used, thereby producing an effect that the oscillator can be operated in a highly stable (high Q) state.

### Industrial Applicability

The present invention is suitable for an oscillator which easily corrects a frequency deviation caused by a temperature fluctuation, achieves miniaturization and realizes a highly stable state.

## Claims

1. An oscillator which supplies a reference signal to a system device processing unit, comprising:
a third or higher overtone crystal unit;
an oscillation circuit which is connected to the crystal unit to output an oscillation frequency to the system device processing unit;
a temperature sensor which detects a temperature around the crystal unit; and
a memory which stores information to correct a frequency deviation of the oscillation frequency based on temperature characteristics of the crystal unit and which supplies the information to correct the frequency deviation to the system device processing unit.

2. The oscillator according to claim 1, further comprising:
a buffer which is interposed between the oscillation circuit and the system device processing unit to input the oscillation frequency from the oscillation circuit and to output the oscillation frequency to the system device processing unit, thereby suppressing an influence of a load on an output side.

3. The oscillator according to claim 2, further comprising:
a divider which is interposed between the oscillation circuit and the buffer to divide the oscillation frequency from the oscillation circuit.

4. The oscillator according to claim 3, further comprising:
a buffer which is interposed between the oscillation circuit and the divider to suppress an influence of a load in the divider.

5. The oscillator according to any one of claims 1 to 4, wherein the memory stores, as the information to correct the frequency deviation, a frequency deviation amount corresponding to a value of the temperature in a table, and outputs contents of the table to the system device processing unit.

6. The oscillator according to any one of claims 1 to 4, wherein the memory stores, as the information to correct the frequency deviation, a coefficient of a calculating equation to calculate the frequency deviation amount corresponding to the value of the temperature, and outputs the coefficient of the calculating equation to the system device processing unit.

7. The oscillator according to any one of claims 1 to 6, wherein constituent components other than the crystal unit are integrated and disposed in an integrated circuit.
